# EUROPÄISCHE PATENTANMELDUNG

(11) **EP 2 738 990 A1**
(43) Veröffentlichungstag der Anmeldung: **04.06.2014**
(21) Anmeldenummer: 13193989.4
(22) Anmeldetag: 22.11.2013
(51) Int. Cl.: H04L 25/26, H03K 17/0814, H03K 17/795, H04B 10/80, H02H 9/00, H02H 3/02, H02H 9/04

(54) **Schaltunganordnung mit einem Überlastschutz für galvanische Trenneinheiten**

(30) Priorität: 22.11.2012 DE 102012111278
(71) Anmelder: Wago Verwaltungsgesellschaft mbH, 32423 Minden (DE)
(72) Erfinder: Voß, Christian, 32427 Minden (DE)
(74) Vertreter: Hess, Peter K. G.

(57) **Zusammenfassung**

Eine Schaltungsanordnung mit einem Überlastschutz für galvanische Trenneinheiten (OK1, OK2, ..., OKₙ) zur galvanischen Trennung voneinander wird beschrieben. Die galvanischen Trenneinheiten haben jeweils zwei galvanisch voneinander getrennte Bereiche und einer der Bereiche einen Steuersignalanschluss (S) und einen Basisanschluss (B). Die Schaltungsanordnung haben mindestens zwei solche galvanische Trenneinheiten (OK1, OK2, ..., OKₙ). Von mindestens zwei der galvanischen Trenneinheiten (OK1, OK2, ..., OKₙ) sind die Basisanschlüsse (B) eines Bereichs miteinander elektrisch leitend verbunden und über eine gemeinsame, in Reihe geschaltete Sicherung (F) mit einem Basispotential (GND) verbunden.

## Beschreibung

Die Erfindung betrifft eine Schaltungsanordnung mit einem Überlastschutz für galvanische Trenneinheiten zur galvanischen Trennung von Schaltungsbereichen voneinander, wobei die galvanischen Trenneinheiten jeweils zwei galvanisch voneinander getrennte Bereiche haben und mindestens einer der Bereiche einen Steuersignalanschluss und einen Basissignalanschluss hat, wobei die Schaltungsanordnung mindestens zwei solche galvanische Trenneinheiten hat.

Derartige Schaltungsanordnungen werden insbesondere in Eingabe- und/oder Ausgabe-Modulen in eigensicheren, explosionsgeschützten Bereichen benötigt. Sie werden in Verbindung mit Industriesteuerungen und der Gebäudeautomatisation eingesetzt. Bei der Übertragung von elektrischen Signalen im Übergangsbereich zwischen eigensicheren und nicht eigensicheren Bereichen sind besondere Vorschriften zu erfüllen. Diese Schaltungsbereiche sind galvanisch voneinander zu trennen, so dass der Energieübertragung zwischen diesen galvanisch voneinander zu trennenden Schaltungsbereichen auf ein Mindestmaß beschränkt wird. Hierzu werden galvanische Trenneinheiten, wie insbesondere Optokoppler eingesetzt.

Für die Zulassung im explosionsgefährdeten Bereich müssen solche Optokoppler die erforderlichen Luft- und Kriechstrecken einhalten. Dies erfordert zusätzlichen besonderen Aufwand.

DE 299 08 588 U1 beschreibt eine Vorrichtung zur eigensicheren optischen Datenübertragung zwischen einem eigensicheren Teil und einem nicht eigensicheren Teil einer elektrischen Einrichtung, bei der die Sendediode auf der einen Seite und der Strahlungsempfänger auf der anderen Seite als voneinander getrennte elektrooptische Bauteile ausgebildet sind. Die Sendediode emittiert Strahlung zu dem Strahlungsempfänger über eine freie Strecke. Durch diesen Aufbau, bei dem Sendediode und Strahlungsempfänger als voneinander völlig getrennte diskrete Bauteile aufgebaut sind, wird erreicht, dass der eigensichere und der nicht eigensichere Teil der elektrischen Einrichtung vollständig galvanisch voneinander getrennt werden.

In diesem Zusammenhang ist aus DE 39 07 033 A1 bekannt, einen Lichtleiter zwischen der Sendediode und dem hiervon separaten Strahlungsempfänger anzuordnen, wobei die Sendediode von einer eigenen Spannungsversorgung im eigensicheren Bereich gespeist wird.

Diese Lösungen benötigen zusätzlichen Platz und aufgrund der voneinander unabhängigen Sende- und Empfangsbauteile zusätzlichen Aufwand.

Eine galvanische Trennung ist unter Einhaltung der bestehenden Sicherheitsnormen, wie z. B. EN 50 020, unter Verwendung von Standard-Optokopplern zulässig, wenn eine Überspannungsschutzeinrichtung vorhanden ist. Eine solche Überspannungsschutzeinrichtung ist in DE 44 36 858 C2 beschrieben. Sie hat wenigstens zwei Begrenzungsglieder. Jedes Begrenzungsglied kann entweder von einem einzigen Begrenzungselement oder einer Serienschaltung von wenigstens zwei Begrenzungselementen gebildet sein, wobei als Begrenzungselemente vor allem Zenerdioden, Dioden, Varistoren oder ähnliches geeignet sind.

Dabei ist ein Begrenzungselement jeweils in den Vorsorgungspfad des zugeordneten Optokopplers geschaltet. Auf diese Weise wird verhindert, dass im Überspannungsfall der durch das zugeordnete Begrenzungselement, wie beispielsweise eine Sicherung, geschützte Optokoppler zerstört und eine leitende Verbindung ggf. mit Funkenbildung zwischen dem nicht eigensicheren und dem eigensicheren Bereich des Optokopplers hergestellt wird.

Ausgehend hiervon ist es Aufgabe der vorliegenden Erfindung eine verbesserte Schaltungsanordnung mit einem Überlastschutz für galvanische Trenneinheiten zu schaffen, bei der unter Sicherstellung des erforderlichen Überlastschutzes Bauraum und Schaltungsaufwand reduziert wird.

Die Aufgabe wird durch die Schaltungsanordnung mit den Merkmalen des Anspruchs 1 gelöst.

Vorteilhafte Ausführungsformen sind in den Unteransprüchen beschrieben.

Für eine gattungsgemäße Schaltungsanordnung wird vorgeschlagen, dass von mindestens zwei galvanischen Trenneinheiten die Basisanschlüsse eines Bereichs miteinander elektrisch leitend verbunden und über eine gemeinsame, in Reihe geschaltete Sicherung, mit einem Basispotential verbunden sind.

Anders als im Stand der Technik, bei dem für jede galvanische Trenneinheit an dem jeweiligen Steuersignalanschluss eine Sicherung vorhanden ist, wird mit der vorliegenden Erfindung vorgeschlagen, eine gemeinsame Sicherung als Überlastschutzelement für mindestens zwei galvanische Trenneinheiten gemeinsam zu nutzen. Dies gelingt dadurch, dass die Sicherung zwischen elektrisch leitend miteinander verbundenen Basisanschlüssen und dem Basispotential geschaltet ist. Bei einem durch mindestens eine der galvanischen Trenneinheiten fließenden und die galvanische Trenneinheit überlastenden Stroms fließt dieser dann über die gemeinsame Sicherung ab und löst die Sicherung, d.h. den Überlastschutz der Überlastschutzeinheit aus. So kann beispielsweise der Schmelzfaden einer Schmelzsicherung bei einem solchen überhöhten Strom aufschmelzen und den Stromfluss durch die galvanischen Trenneinheiten unterbrechen.

Es ist damit nur noch eine einzige gemeinsame Sicherung anstelle der bislang in dem Versorgungspfad jeder galvanischen Trenneinheit geschalteten mehreren Sicherungen erforderlich. Damit wird Bauraum und Aufwand für Bauteile eingespart.

Da im Fehlerfall ohnehin die gesamte Baugruppe ausgetauscht werden muss, entsteht durch die gemeinsame Absicherung der galvanischen Trenneinheiten kein Nachteil.

Besonders vorteilhaft ist es, wenn ein weiteres Überspannungsschutzelement jeweils parallel zu einem zugeordneten galvanischen Trenneinheit zwischen der zum Signaleinheit zugeordneten galvanischen Trenneinheit führenden Signalpfad und dem vom Basisausgang der zugeordneten galvanischen Trenneinheit abgehenden Signalpfad geschaltet ist. Mit einem solchen parallel zur galvanischen Trenneinheit jeweils geschalteten Überspannungsschutzelement wird die galvanische Trenneinheit vor zu hohen Spannungen geschützt. Als ein solches Überspannungsschutzelement eignet sich insbesondere eine Zenerdiode. Bei einer Überspannung wird der entsprechende Strom dann zum Basispotential hin abgeleitet und die gemeinsame Sicherung ausgelöst, wenn der zulässige maximale Strom überschritten wird.

Besonders vorteilhaft ist es, wenn an dem Steuersignalanschluss der galvanischen Trenneinheit jeweils ein Widerstand in Reihe geschaltet ist und das als Begrenzungselement wirkende Überspannungsschutzelement mit dem zwischengeschalteten Widerstand parallel zu dem Steuersignalanschluss und Basisanschluss eines jeweiligen galvanischen Trennelements liegt.

Das Überspannungsschutzelement dient der Spannungsbegrenzung und ist besonders vorteilhaft als Zenerdiode ausgeführt. Als Überlastschutzelement wird eine Sicherung eingesetzt, wie beispielsweise eine Schmelzsicherung.

Die Steuersignalanschlüsse der galvanischen Trenneinheiten sind vorzugsweise direkt oder indirekt (z. B. mit zwischengeschalteten Widerständen) an einen zugeordneten Steuersignalausgang einer Steuerungseinheit geschaltet. Die Steuerungseinheit dient zur Ansteuerung der galvanischen Trenneinheiten mittels Steuersignalen oder zum Empfang von Steuersignalen folgender galvanischer Trenneinheit, die mit Hilfe der galvanischen Trenneinheit an den galvanisch getrennten anderen Schaltungsbereich übertragen oder von diesem Schaltungsbereich empfangen werden. Als Steuerungseinheit dient insbesondere ein Mikrocontroller, Mikroprozessor, FPGA (Field Programmable Gate Array) oder ASIC (Anwenderspezifische Integrierte Schaltung), die vorzugsweise Teil einer Automatisierungseinrichtung (Industriesteuerung, Gebäudeautomatisierung, Verkehrsmittelsteuerung etc.) ist.

Die galvanischen Trenneinheiten sind vorzugsweise über ein gemeinsames Überlastschutzelement (Sicherung) mit Massepotential verbunden. Denkbar ist aber auch, dass die Basisausgänge der galvanischen Trenneinheiten über das gemeinsame Überlastschutzelement mit Versorgungsspannungspotential verbunden sind.

Als galvanische Trenneinheiten sind besonders vorteilhaft Optokoppler verwendbar.

Die Erfindung wird nachfolgend anhand von Ausführungsbeispielen mit der beigefügten Zeichnung beispielhaft näher erläutert. Es zeigt:
- Figur 1: - Diagramm einer Schaltungsanordnung mit Überlastschutz für Optokoppler, zum Leiten von Signalen aus einem EX-Bereich zu einer Steuerung;
- Figur 2: - Diagramm einer Schaltungsanordnung mit Überlastschutz für Optokoppler zum Leiten von Signalen von einer Steuerung in einen EX-Bereich
- Figur 3: - Diagramm einer Schaltungsanordnung als Kombination der Schaltungsanordnung aus Figur 1 und 2.

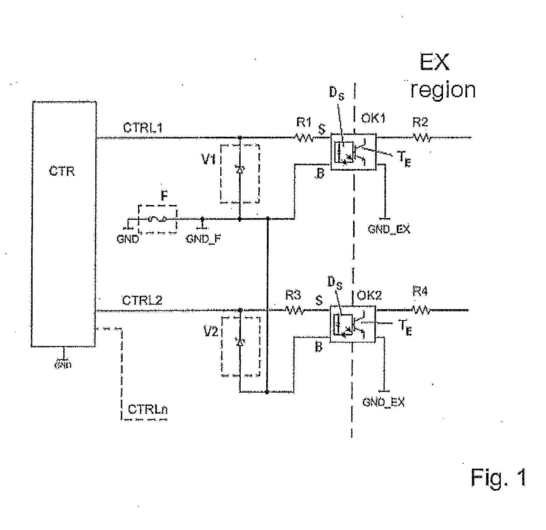

Figur 1 lässt ein Diagramm einer Schaltungsanordnung erkennen, mit dem eine Anzahl von mindestens zwei Optokopplern OK1, OK2, ..., OKn als galvanische Trenneinheiten vor Überlastung geschützt werden können. Die Optokoppler OK1, OK2, ..., OKn sind zur galvanischen Trennung eines eigensicheren Bereiches (EX-Bereich) und eines nicht-eigensicheren Bereichs (linker Bereich) vorgesehen. Der eigensichere Bereich ist insbesondere ein explosionsgeschützter Bereich, für den besondere Anforderungen gelten, wie sie z. B. in der Norm DIN EN 60079-11 (VDE 0170-7) definiert sind.

Die galvanischen Trenneinheiten OK1, OK2, ..., OKn haben im nichtexplosionsgeschützten Bereich jeweils einen Steuersignalanschluss S und einen Basisanschluss B. Im explosionsgeschützten Bereich EX-Bereich ist in entsprechender Weise ein Steuersignalanschluss S_EX und ein Basisanschluss B_EX vorgesehen. Der Signalanschluss S_EX des eigensicheren Bereichs EX-Bereich ist über einen Widerstand R2 an eine anzusteuernde Last (nicht dargestellt) geführt. Der Basisanschluss B_EX ist mit Massepotential GND_EX des eigensicheren Bereichs (EX-Bereich) verbunden.

Die als Optokoppler ausgeführten galvanischen Trenneinheiten OK1, OK2, ..., OKn haben jeweils für den eigensicheren Bereich (EX-Bereich) eine optische Empfangseinheit beispielsweise in Form einer Fotodiode oder eines Fototransistors T. Im nicht-eigensicheren Bereich ist eine optische Sendeeinheit beispielsweise in Form einer Leuchtdiode im sichtbaren oder nicht-sichtbaren Lichtwellenbereich vorhanden und mit dem Steuersignalanschluss S und Basisanschluss B des nicht-eigensicheren Bereichs verbunden.

Die beispielhaft skizzierte Schaltungsanordnung ist somit zum Leiten von Signalen von einer Steuerungseinheit CTR zu Empfängern (nicht dargestellt) in dem eigensicheren Bereich (EX-Bereich) vorgesehen.

Deutlich wird, dass die galvanischen Trennelemente OK1, OK2 über Steuersignalausgänge CTRL1, CTRL2, ..., CTRLₙ einer Steuerungseinheit CTR angesteuert sind. Hierzu ist zwischen dem Steuersignalausgang CTRL1, CTRL2, ..., CTRLₙ und dem jeweils zugeordneten Steuersignalanschluss S1, S2, ..., Sₙ des galvanischen Trennelements OK1, OK2, ..., OKₙ ein Widerstand R1, R3, ... in Reihe geschaltet.

Zur Verhinderung einer Überspannung über dem nicht-eigensicheren Eingang (Steuersignalanschluss S und Basisanschluss B der galvanischen Trennelemente) ist ein Überspannungsschutzelement V1, V2, ..., Vₙ (Begrenzungselement) parallel geschaltet, wobei der Serienwiderstand R1, R3 unmittelbar vor den Steuersignalanschluss S geschaltet ist. Das Überspannungschutzelement V1, V2, das insbesondere als Zenerdiode ausgeführt sein kann, ist somit mit dem zwischengeschalteten Widerstand R1, R3 parallel zu dem Steuersignalanschluss S und dem Basisanschluss auf der nicht-eigensicheren Seite des jeweiligen galvanischen Trennelements OK1, OK2, ..., OKₙ geschaltet.

Deutlich wird weiterhin, dass die Basisanschlüsse B der galvanischen Trennelemente OK1, OK2, ..., OKₙ zusammengeschaltet sind, d. h. in direkter elektrisch leitender Verbindung ohne zwischengeschaltetes weiteres elektronisches Bauelement miteinander verbunden sind.

In dem dargestellten Ausführungsbeispiel sind die Basisanschlüsse B mit einem ersten Massebereich der Schaltungsanordnung verbunden. Über ein gemeinsames Überlastschutzelement, d.h. über die Sicherung F sind die Basisanschlüsse B mit einem Basispotential GND verbunden.

Bei weiteren optional vorhandenen galvanischen Trennelementen OKₙ können die Basisanschlüsse dieser weiteren galvanischen Trenneinheiten OKₙ ebenfalls mit der Masse GND_F und den Basisanschlüssen der anderen galvanischen Trenneinheiten OK1, OK2, ..., OKₙ verbunden sein. Denkbar ist aber auch, dass galvanische Trenneinheiten OK1, OK2, ..., OKₙ in Gruppen miteinander so verschaltet sind, dass jeweils die Basisanschlüsse B einer Gruppe über eine gemeinsame Sicherung F mit einer gemeinsamen Masse GND verbunden sind. Eine solche Gruppe von miteinander verschalteten galvanischen Trennelementen OK1, OK2, ..., OKₙ kann beispielsweise aus zwei, drei, vier, fünf, sechs oder mehr solchen galvanischen Trenneinheiten OK1, OK2, ..., OKₙ bestehen.

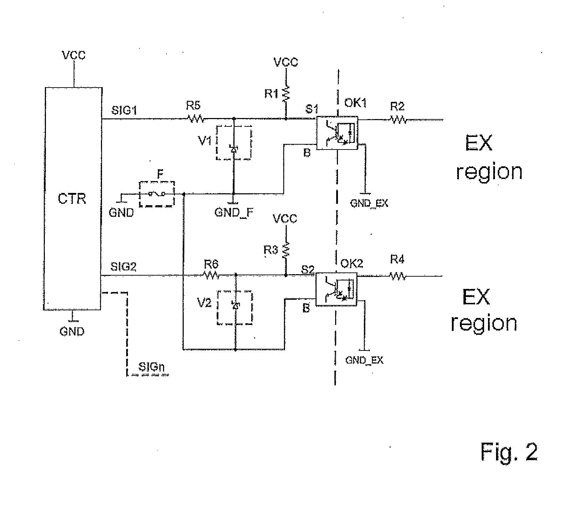

Figur 2 lässt ein Diagramm einer Schaltungsanordnung erkennen, mit dem Signale von der Steuerungseinheit CTR (Controller, ASIC o.ä.) über die Optokoppler OK1, OK2, ...., OKₙ als galvanische Trenneinheiten in den eigensicheren Bereich (EX-Bereich) zu dort angeordneten Verbrauchern/Empfängern übertragen werden können. Hier wiederum sind die Basisanschlüsse B der Optokoppler OK1, OK2, ..., OKₙ über eine gemeinsame Sicherung F mit dem Basispotential GND verbunden.

Im Unterschied zur Variante gemäß Figur 1 sind die Steuersignalanschlüsse S der Optokoppler OK1, OK2, ..., OKₙ über jeweils einen Widerstand R1, R3 an Versorgungsspannungspotenzial VCC gelegt. Die Übersteuerungsschutzelemente V1, V2, ..., Vₙ sind parallel zwischen dem Steuersignalanschluss S1, S2 und dem Basisanschluss B des zugeordneten Optokopplers OK1, OK2, ..., OKₙ geschaltet. Die jeweiligen Signalanschlüsse SIG1, SIG2, ..., SIG_{N} der Steuerungseinheit CTR sind in jeweils über einen Serienwiderstand R5, R6, ... mit einem zugeordneten Steuersignalanschluss S1, S2, ..., Sₙ verbunden.

Die Optokoppler OK1, OK2, ..., OKₙ sind nun so geschaltet, dass ein Fototransistor zwischen den Steuersignalanschluss S1, S2 und den Basisanschluss B eine als Optokoppler OK1, OK2, ..., OKₙ geschaltet ist. Im eigensicheren Bereich (EX-Bereich) befindet sich dann die optische Sendeeinheit in Form einer Leuchtdiode, die über einen jeweiligen Serienwiderstand R2, R4 angesteuert und mit ihrer Kathode an Massenpotential GND_EX des eigensicheren Bereichs (EX-Bereich) liegt.

In dem dargestellten Ausführungsbeispiel sind die Optokoppler OK1, OK2, ..., OKₙ somit genau umgekehrt zur ersten Variante gemäß Figur 1 zwischen dem Bereich der Steuerungseinheit CTR und dem eigensicheren Bereich (EX-Bereich) verschaltet.

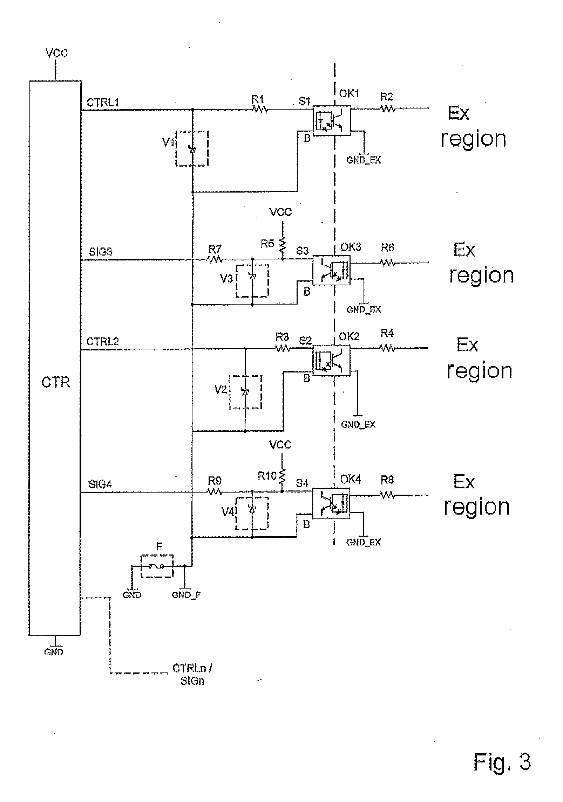

Figur 3 lässt ein Diagramm einer Schaltungsanordnung erkennen, bei der die Schaltungsanordnung gemäß Figur 1 und 2 miteinander kombiniert sind.

Erkennbar ist, dass unabhängig von der Signalrichtung von der Steuerungseinheit CDR in den eigensicheren Bereich (EX-Bereich) oder umgekehrt und damit unabhängig von der Verschaltungsrichtung der Optokoppler OK1, OK2, OK3, OK4, ..., OKₙ die Basisanschlüsse B der Optokoppler OK1, OK2, OK3, OK4, ..., OKₙ alle zusammengeschaltet und mit über eine gemeinsame Sicherung F mit dem Basispotential GND verbunden sind.

Lediglich die Verbindung der Steuersignaleingänge SIG3, SIG4, ..., SIGₙ und der Steuersignalausgänge CTRL1, CTRL2, ..., CTRLₙ mit den zugeordneten Steuersignalanschlüssen S1, S2, S3, S4, ..., Sₙ der Optokoppler OK1, OK2, OK3, OK4, ..., OKₙ ist entsprechend der in Figur 1 und 2 für die Signalrichtungen gezeigten Varianten durch die spezielle Verschaltung der in Reihe geschalteten Widerstände R1, R3 bzw. R7, R9 und für die Steuersignaleingänge durch die Pull-Up-Widerstände R5, R10 an Versorgungsspannungspotential VCC an die Signalrichtung angepasst.

## Patentansprüche

1. Schaltungsanordnung mit einem Überlastschutz für galvanische Trenneinheiten (OK1, OK2, ..., OKₙ) zur galvanischen Trennung voneinander, wobei die galvanischen Trenneinheiten jeweils zwei galvanisch voneinander getrennte Bereiche haben und einer der Bereiche einen Steuersignalanschluss (S) und einen Basisanschluss (B) hat, wobei die Schaltungsanordnung mindestens zwei solche galvanische Trenneinheiten (OK1, OK2, ..., OKₙ) hat, **dadurch gekennzeichnet, dass** von mindestens zwei der galvanischen Trenneinheiten (OK1, OK2, ..., OKₙ) die Basisanschlüsse (B) eines Bereichs miteinander elektrisch leitend verbunden und über eine gemeinsame, in Reihe geschaltete Sicherung (F) mit einem Basispotential (GND) verbunden sind.

2. Schaltungsanordnung nach Anspruch 1, **dadurch gekennzeichnet, dass** ein Überspannungsschutzelement (V₁, V₂) jeweils parallel zu einer zugeordneten galvanischen Trenneinheit (OK1, OK2, ..., OKₙ) zwischen dem zum Steuersignalanschluss (S) der zugeordneten galvanischen Trenneinheit (OK1, OK2, ..., OKₙ) führenden Signalpfad und dem vom Basisanschluss (B) der zugeordneten galvanischen Trenneinheit (OK1, OK2, ..., OKₙ) abgehenden und mit der gemeinsamen Sicherung (F) verbundenen Signalpfad geschaltet ist.

3. Schaltungsanordnung nach Anspruch 2, **dadurch gekennzeichnet, dass** an den Steuersignalanschluss (S) der galvanischen Trenneinheiten (OK1, OK2, ..., OKₙ) jeweils ein Widerstand (R₁, R₃) in Reihe geschaltet ist und das Überspannungsschutzelement (V₁, V₂) mit dem zwischengeschalteten Widerstand (R₁, R₃) parallel zwischen dem Steuersignalanschluss (S) und Basisanschluss (B) eines Bereichs der galvanischen Trenneinheit (OK1, OK2, ..., OKₙ) liegt.

4. Schaltungsanordnung nach Anspruch 2 oder 3, **dadurch gekennzeichnet, dass** die Überspannungsschutzeelemente (V₁, V₂) Zenerdioden sind.

5. Schaltungsanordnung nach einem der vorhergehenden Ansprüche, **dadurch gekennzeichnet, dass** die Steuersignalanschlüsse (S) der galvanischen Trenneinheiten (OK1, OK2, ..., OKₙ) direkt oder indirekt jeweils an einen zugeordneten Steuersignalanschluss (CTRL1, CTRL2, ..., CTRLn) einer Steuerungseinheit (CTR) geschaltet sind.

6. Schaltungsanordnung nach einem der vorhergehenden Ansprüche, **dadurch gekennzeichnet, dass** die galvanischen Trenneinheiten Optokoppler (OK1, OK2, ..., OKₙ) sind.

7. Schaltungsanordnung nach einem der vorhergehenden Ansprüche, **dadurch gekennzeichnet, dass** Optokoppler (OK1, OK2, ..., OKₙ) jeweils eine Sendediode zwischen dem Steuersignalanschluss (S) und dem mit der gemeinsamen Sicherung (F) verbundenen Basisanschluss (B) haben.

8. Schaltungsanordnung nach einem der vorhergehenden Ansprüche, **dadurch gekennzeichnet, dass** Optokoppler (OK1, OK2, ..., OKₙ) jeweils einen Fototransistor zwischen dem Steuersignalanschluss (S) und dem mit der gemeinsamen Sicherung (F) verbundenen Basisanschluss (B) zur Ausgabe eines Steuersignals an dem Steuersignalanschluss (S) haben.
